# EUROPÄISCHE PATENTANMELDUNG

(11) **EP 0 646 955 A2**
(43) Veröffentlichungstag der Anmeldung: **05.04.1995**
(21) Anmeldenummer: 94115491.6
(22) Anmeldetag: 30.09.1994
(51) Int. Cl.: H01L 21/56, H01L 23/433

(54) **Vorrichtung zum Umhüllen eines Halbleiterbauelements und einer damit verbundenen Wärmesenke mit Kunststoffen**

(30) Priorität: 30.09.1993 DE 4333415
(71) Anmelder: SIEMENS AKTIENGESELLSCHAFT, D-80333 München (DE)
(72) Erfinder: Ernst, Georg, D-93107 Thalmassing (DE)

(57) **Zusammenfassung**

Um beim Umhüllen eines Halbleiterbauelements (3) und einer damit verbundenen Wärmesenke (6), die an einer Außenfläche nicht umhüllt werden soll, ein Entstehen eines dünnen Kunststoffilms aufgrund von Werkstofftoleranzen und Spalten auf der äußeren Oberfläche der Wärmesenke zu verhindern, wird vorgeschlagen, zwischen die Wärmesenke (6) und ein zugeordnetes Formteil (1) der formgebenden Vorrichtung (1, 2) eine Folie (8) anzuordnen. Die Folie kann dabei aus Papier oder Polyester bestehen.

## Beschreibung

Die Erfindung betrifft eine Vorrichtung zum formgebenden Umhüllen eines Halbleiterbauelements und einer damit verbundenen Wärmesenke mit Kunststoffen.

Kunststoffe für Halbleitergehäuse, üblicherweise duroplastische und thermoplastische Formmassen werden unter Einwirkung von Temperatur und Druck in speziellen Werkzeugen zu Gehäusen bzw. Formstoffen verarbeitet. Üblicherweise bestehen die Vorrichtungen zum formgebenden Umhüllen, d.h. die Verarbeitungswerkszeuge aus mehreren Teilen, die sich nach jedem Verfahrensschritt bzw. am Schluß des Verfahrens zum Entformen der Formstoffe öffnen. Beim Schließen der Werkzeugteile entstehen an den Trennebenen wegen der unvermeidlichen Werkstofftoleranzen Spalten, durch die der Kunststoff als dünner Film, sogenannter Flash, während der Bearbeitung austritt. So fließt bei der Umhüllung von Metallbändern, die teilweise mit Kunststoff umhüllt werden sollen, durch die Spalten zwischen den in der Form befindlichen eingelegten Teilen und dem Werkzeug der Kunststoff als dünner Film auch auf die Fläche, die nicht umhüllt werden soll. Zur Lösung dieses Problems schlägt die DE-A-27 38 009 vor, daß der Kunststoff durch Folien abgedichtet wird, die das abzudichtende Element so umhüllen, daß beim Herunterfahren des Oberteils der Vorrichtung dieses nicht in Kontakt mit dem Unterteil kommt, so daß Oberteil und Unterteil der Vorrichtung gegen die Abdichtfolie gepreßt werden, wobei kein Spalt entstehen kann.

Ein ähnliches Problem entsteht beim Umhüllen von Leistungsbauelementen, die zur Wärmeabfuhr mit einem Metallteil verbunden sind, das mit einer Außenfläche aus dem Gehäuse herausragt und direkt kontaktiert werden kann. Dadurch wird die Wärmeabfuhr des Chips, die üblicherweise über den Leadframe und das Gehäuse erfolgt, verbessert. Mit Hilfe einer derartigen metallenen Wärmesenke kann der Chip einen wesentlichen Teil seiner Wärme direkt an die Wärmesenke abgeben, die die Wärme durch Wärmeleitung überträgt, wo sie zusätzlich zu den bisher bekannten Wärmeabfuhrmechanismen zur Kühlung des Chips durch Konvektion und Strahlung beiträgt.

Beim Umhüllen derartiger Bauelemente mit Wärmesenke entsteht jedoch typischerweise ein dünner Kunststoffilm (Flash) auf der Oberfläche der Wärmesenke, da die Wärmesenke nicht durch eine Abdichtung und einen vom Oberteil und Unterteil des Werkzeugs ausgeübten Druck abgedichtet werden kann. Dies liegt daran, daß die Wärmesenke von den Werkzeugteilen nicht direkt auf Druck beansprucht wird.

Typischerweise muß deshalb der auf der Wärmesenke gebildete Flash durch aufwendige und teuere Arbeitsgänge entfernt werden. Hierzu gehört ein Anlösen bzw. Aufweichen des Flash durch Chemikalien wie Ameisensäure, Milchsäure oder anderen. Eine weitere Möglichkeit besteht im Strahlen (jetdeflashing) der Wärmesenke mit Wasser, das unter hohem bzw. niedrigem Druck steht. Es ist auch möglich, mit Wasser zu strahlen, welches mit Feststoffpartikeln angereichert ist (wet blasting). Bei nicht vollständiger Entfernung des Flash muß nachgearbeitet werden. Dies geschieht durch Abschleifen der Wärmesenke mit einer Schmirgelscheibe.

Der Erfindung liegt die Aufgabe zugrunde, eine einfachere und billigere Möglichkeit zum Umhüllen eines Halbleiterbauelements und einer damit verbundenen Wärmesenke anzugeben.

Diese Aufgabe wird mit den Merkmalen des Patentanspruchs 1 gelöst.

Als klebende Folien sind Papier oder Polyesterfolien mit einseitiger oder beidseitiger Klebefläche geeignet. Die Folie wird flächig auf die Wärmesenke oder das Werkzeugunterteil geklebt und dann der Chip mit Wärmesenke in das Unterteil des Werkzeugs eingebracht. Vorzugsweise hat das Unterteil eine Wanne, die im wesentlichen in ihren lateralen Abmessungen der Wärmesenke entspricht. Die Folie mit der darüber angeordneten Warmesenke und dem Chip werden in diese Wanne eingelegt und können ggf. bei einer beidseitig klebenden Folie damit verklebt werden. Anschließend wird auf übliche Weise das Oberteil der Umhüllungsvorrichtung nach unten auf das Unterteil zugefahren, und der Kunststoff wird in die Werkzeugkavität eingespritzt.

Die als Abdichtung verwendete Folie hat die Eigenschaften, daß sie einerseits formbeständig unter Einwirkung von Temperatur und Druck derart ist, daß die Abdichtung während des Umhüllungsvorgangs nicht zerstört wird. Andererseits ist die Folie so elastisch und plastisch deformierbar, daß eventuelle Unebenheiten ausgeglichen werden. Darüber hinaus kann die Folie so gewählt werden, daß der zu verarbeitende Kunststoff nicht an der Folie haftet.

Wenn eine Folie verwendet wird, die mit der Wärmesenke verklebt ist, muß sie nach jedem Umhüllungsvorgang von der Wärmesenke entfernt werden, was einen hohen Verschleiß bedeutet. Es ist aber auch möglich, die Folien nur mit dem Unterteil des Werkzeugs zu verkleben und die zu umhüllende Wärmesenke mit dem aufgebrachten Chip unter geringem Druck in die mit der Folie ausgelegte Wanne zu drücken. Diese Maßnahme reicht typischerweise bereits aus, einen dünnen Kunststoffilm auf der Unterseite der Wärmesenke zu verhindern.

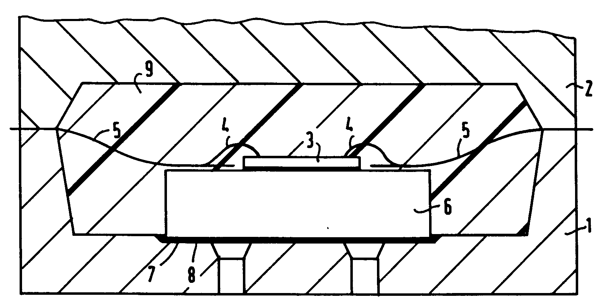

Nachfolgend wird die Erfindung anhand einer Zeichnung näher erläutert. Die Figur zeigt einen Schnitt durch eine erfindungsgemäße Vorrichtung.

In dem Werkzeug mit dem Unterteil 1 und dem Oberteil 2 ist ein Chip 3 angeordnet, dessen Anschlußflecken über Anschlußdrähte 4 mit von außen zugänglichen Anschlüssen 5 des Leiterbandes verbunden sind. Ebenfalls mit dem Chip 3 ist eine Wärmesenke 6 thermisch eng verbunden. Das Unterteil der Umhüllungsvorrichtung hat eine Wanne 7, in die eine Folie 8 eingelegt ist, die für einen engen Kontakt zwischen der Wärmesenke 6 und der Wanne 7 bzw. dem Unterteil 1 der Vorrichtung sorgt. Beim Umspritzen der Anordnung mit Preßmasse 9 durch einen nicht gezeigten Kanal kann die Preßmasse nicht auf die der Folie 8 zugewandte Oberfläche der Wärmesenke 6 gelangen. Nach dem Umhüllen der Anordnung wird das Oberteil der Vorrichtung hochgefahren, der mit der Preßmasse umhüllte und mit der Wärmesenke verbundene Chip 3 aus dem Unterteil des Werkzeugs herausgenommen und für den nächsten Umhüllungsvorgang ein neuer Chip mit Wärmesenke eingelegt.

## Patentansprüche

1. Vorrichtung zum formgebenden Umhüllen eines Halbleiterbauelements und einer damit verbundenen Wärmesenke mit einem Kunststoff,
**gekennzeichnet** durch eine zwischen die Wärmesenke (6) und ein zugeordnetes Formteil (1) der Vorrichtung angeordnete verklebt Folie (8), wobei eine nicht zu umhüllende Oberfläche der Wärmesenke vollständig mit der Folie bedeckt ist.

2. Vorrichtung nach Anspruch 1,
**dadurch gekennzeichnet,** daß die Folie Papier oder Polyester mit einer Klebeschicht enthält.

3. Vorrichtung nach Anspruch 1 oder 2,
**dadurch gekennzeichnet,** daß das der Wärmesenke (6) zugeordnete Formteil (1) der Vorrichtung eine Wanne (7) enthält, in der die Folie angeordnet ist und die in ihren lateralen Abmessungen den lateralen Abmessungen der Wärmesenke entspricht.
